# EUROPEAN PATENT SPECIFICATION

(11) **EP 1 243 109 B1**
(45) Date of publication and mention of the grant of the patent: **26.07.2006**
(21) Application number: 00976520.7
(22) Date of filing: 10.11.2000
(51) Int. Cl.: H04L 25/00, H03F 1/30

(54) **AN ARRANGEMENT FOR REDUCING POWER DISSIPATION IN A LINE DRIVER**
EINRICHTUNG ZUR VERRINGERUNG VON LEISTUNGSVERLUSTEN IN EINEM LEITUNGSTREIBER
AGENCEMENT PERMETTANT DE REDUIRE LA DISSIPATION DE PUISSANCE DANS UN CIRCUIT DE COMMANDE DE LIGNE

(30) Priority: 17.12.1999 SE 9904642
(43) Date of publication of application: 25.09.2002
(73) Proprietor: TELEFONAKTIEBOLAGET LM ERICSSON (publ), 164 83 Stockholm (SE)
(72) Inventor: BARKARÖ, Stefan, S-184 60 Akersberga (SE)
(74) Representative: Sjöberg, Mats Hakan
(86) International application number: PCT/SE2000/002201
(87) International publication number: WO 2001/045336

(56) References cited:
- WO-A1-99/18662
- US-A- 5 585 744

## Description

### TECHNICAL FIELD

The invention relates generally to line drivers, and more specifically to an arrangement for reducing power dissipation in line drivers connected to transmission lines in multitone systems, such as e.g. ADSL (Asymmetric Digital Subscriber Line) systems.

### BACKGROUND OF THE INVENTION

In a multitone system, such as an ADSL-system, data information is randomly coded into the phase and amplitude of a plurality of sine tones that are transmitted by line drivers on transmission lines in bursts with a so-called symbol rate or length, which in the ADSL case is 246.3 µs.

To enable Fourier transformations to be made on each symbol, a so-called cyclic prefix is inserted between the symbols. The cyclic prefix does not contain any valid data but ensures that the multitone signal appears continuous for the Fourier transformation.

In the ADSL case, each cyclic prefix has a length of 32 samples or about 15 µs.

Since the phase and amplitude of each individual tone can be seen as random and the total signal consists of a sum of many tones, there will be a great difference between successive symbols in the peak-to-peak voltage of the total signal that is to be transmitted.

In view hereof, in normal ADSL systems, the supply voltage of the line drivers that are connected to the transmission line for transmitting such multitone signals must be selected such that the theoretical maximum peak can be transmitted without being clipped.

This causes the supply voltage of the line driver to be far too high for the majority of the symbols that are transmitted.

Consequently, the power dissipation in the line driver will be higher than necessary for most of the symbols.

In the international patent application WO 99/18662 is disclosed a method for reducing the power dissipated by an amplifier circuit. In particular, the power supplied to the amplifier circuit is changed depending on the level of input signal to that circuit. A higher power is supplied to the amplifier circuit when the level of the input signal exceeds a threshold. Otherwise, a lower power is supplied to the amplifier circuit. The magnitude of the input signal is detected and compared with the threshold. A control signal is generated based on that comparison to control whether higher or lower power is supplied to the amplifier circuit. The solution in the international application requires a change of power supplied to the amplifier each time a threshold value is exceeded which might cause disturbances within symbols.

### SUMMARY OF THE INVENTION

The object of the invention is to bring about an arrangement for reducing the power dissipation in line drivers.

This is attained essentially in that the supply voltage to the line driver is controlled from symbol to symbol during the cyclic prefixes in response to a known expected peak-to-peak value of the next symbol to be transmitted.

By adapting the supply voltage to expected peak-to-peak values, the power dissipation will be reduced in the line driver.

### BRIEF DESCRIPTION OF THE DRAWING

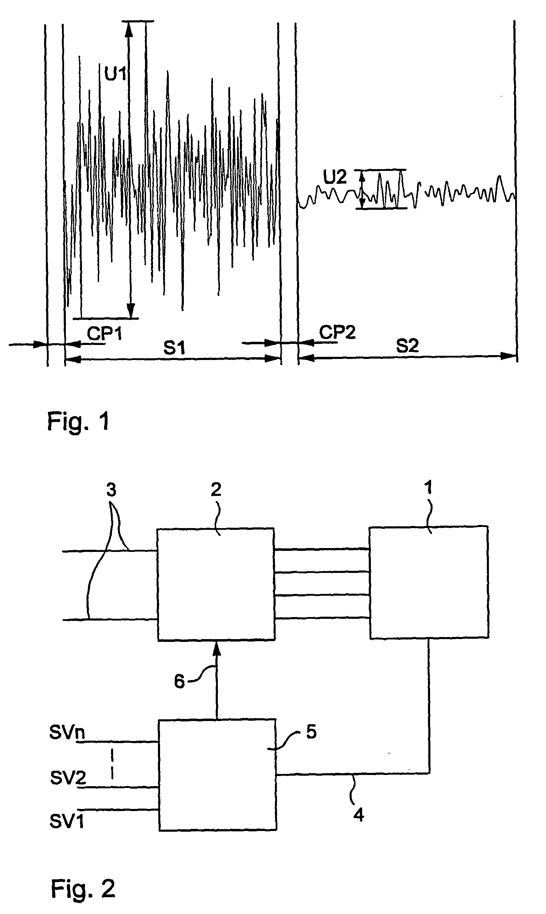

The invention will be described more in detail below with reference to the appended drawing, on which Fig. 1 schematically illustrates two successive symbols to be transmitted in an ADSL system, and Fig. 2 is a schematic block diagram of one end of an ADSL connection with an embodiment of an arrangement according to the invention.

### DESCRIPTION OF THE INVENTION

Fig. 1 schematically illustrates two successive symbols S and S2 to be transmitted in an ADSL system.

In a manner known per se, each symbol S 1 and S2, is preceded by a so-called cyclic prefix CP1 and CP2, respectively.

In ADSL systems, the symbol length is 246.3 µs, while the length of the cyclic prefix is 32 samples or about 15 µs as already mentioned.

In Fig. 1, the peak-to-peak value of the symbol S1 is U1, while the peak-to-peak value of the symbol S2 equals U2, which in Fig. 1 is supposed to be a lower value than U1.

Today, the symbols S1 and S2 illustrated in Fig. 1 are transmitted by a line driver having a constant supply voltage even if they actually do not require the same supply voltage in order to be transmitted without being clipped.

Thus, unnecessary power is consumed today in such line drivers.

In Fig. 2, an arrangement according to the invention for reducing the power dissipation in a line driver is schematically illustrated.

In Fig. 2, a digital signal processor 1 is connected with its digital input/output terminals to corresponding output/input terminals of an analog front end or line driver 2 connected to a transmission line 3 for transmitting and receiving data information in the form of symbols as illustrated in Fig. 1.

In a manner known per se, the line driver 2 comprises a digital-to-analog converter (not shown) for converting digital signals from the digital signal processor 1 into analog signals to be transmitted as symbols in accordance with Fig. 1, and an analog-to-digital converter (not shown) for converting analog symbols received into digital signals to the digital signal processor 1.

Also in a manner known per se, the digital signal processor 1 knows the peak value of the tones to be transmitted in each symbol.

Thus, the digital signal processor 1 has knowledge of the peak value U1 in the symbol S 1 in Fig. 1 before it is transmitted to the line driver 2 as well as of the peak value U2 in the symbol S2 in Fig. 1.

With this knowledge, the digital signal processor 1 can select the most appropriate supply voltage to the driver 2 for each symbol.

An embodiment of an arrangement for enabling such a supply voltage selection is illustrated in Fig. 2.

In the embodiment in Fig. 2, the digital signal processor 1 is connected via a control bus 4 to a switch 5 which is adapted to apply different supply voltages SV1, SV2 ... SVn to a supply voltage input terminal 6 of the driver 2 in response to different control signals from the digital signal processor 1 on the control bus 4.

It should be pointed out in this connection that the different supply voltages do not have to be fixed and be applied by means of a switch but can be supplied e.g. by a controllable DC/DC converter (not shown).

Anyhow, in accordance with the invention, the selection of the appropriate supply voltage to the driver 2 takes place during each cyclic prefix CP1, CP2, i.e. at times when no relevant information is transmitted.

Thus, during each cyclic prefix, an optimum supply voltage for the driver 2 for the next symbol to be transmitted can be selected without causing any disturbances.

By optimizing the supply voltage for each symbol, the total power dissipation of the driver 2 can be considerably reduced.

## Claims

1. An arrangement for reducing power dissipation in a line driver (2), the line driver coupled to a transmission line (3) for transmitting multitone signals in the form of successive symbols (S1, S2) separated by cyclic prefixes (CP1, CP2), generated by a digital signal processor (1), the arrangement comprises a controllable voltage supply (5) having an output terminal and a control input terminal, the output terminal of the controllable voltage supply (5) being connected to a supply voltage terminal (6) of the line driver (2) to supply a controllable supply voltage thereto, the arrangement **characterized in that** the control input terminal of the controllable voltage supply (5) being connected to a control output terminal of the digital signal processor (1) via a control bus (4), the digital signal processor (1) being adapted to control the controllable voltage supply (5) via the control bus (4) during each cyclic prefix (CP1, CP2) by selecting the supply voltage to the line driver (2) in response to an expected peak-to-peak value of the next symbol to be transmitted.

2. The arrangement according to claim 1, the arrangement **characterized in that** the controllable voltage supply comprises a switch (5) which is adapted to apply different supply voltages (SV1, SV2 ... SVn) to the line driver (2) in response to different expected peak-to-peak values of the symbols to be transmitted.

3. The arrangement according to claim 1, the arrangement **characterized in that** the controllable voltage supply comprises a DC/DC converter controlled by the digital signal processor (1).

## Patentansprüche

1. Eine Anordnung zum Reduzieren eines Leistungsverlustes in einem Leitungstreiber (2), wobei der Leitungstreiber gekoppelt ist an eine Übertragungsleitung (3) zum Übertragen von Mehrfachschwingungssignalen in der Form von aufeinander folgenden Symbolen (S1, S2), getrennt durch zyklische Präfixe (CP1, CP2), die von einem digitalen Signalprozessor (1) erzeugt werden, wobei die Anordnung eine kontrollierbare Spannungsversorgung (5) mit einem Ausgabeterminal und einem Kontrolleingabeterminal enthält, wobei das Ausgabeterminal der kontrollierbaren Spannungsversorgung (5) mit einem Versorgungsspannungsterminal (6) des Leitungstreibers (2) verbunden ist, um eine kontrollierbare Versorgungsspannung dazu zu liefern, wobei die Anordnung darin **gekennzeichnet** ist, dass das Kontrolleingabeterminal der kontrollierbaren Spannungsversorgung (5) mit einem Kontrollausgabeterminal des digitalen Signalprozessors (1) über einen Kontrollbus (4) verbunden ist, wobei der digitale Signalprozessor (1) angepasst ist, um die kontrollierbare Spannungsversorgung (5) über den Kontrollbus (4) während jedes zyklischen Präfixes (Cpl, CP2) durch Auswählen der Versorgungsspannung an den Leitungstreiber (2) zu kontrollieren, als Reaktion auf einen erwarteten Spitzen- zu Spitzenwert des nächsten zu übertragenden Symbols.

2. Die Anordnung gemäß Anspruch 1, wobei die Anordnung darin **gekennzeichnet** ist, dass die kontrollierbare Spannungsversorgung einen Schalter (5) enthält, der angepasst ist, um verschiedene Versorgungsspannungen (SV1, SV2 ... SVn) an den Leitungstreiber (2) in Reaktion auf verschieden erwartete Spitzen- zu Spitzenwerte der zu übertragenden Symbole anzulegen.

3. Die Anordnung gemäß Anspruch 1, wobei die Anordnung darin **gekennzeichnet** ist, die kontrollierbare Spannungsversorgung einen DC/DC Konverter enthält, der von dem digitalen Signalprozessor (1) kontrolliert wird.

## Revendications

1. Agencement destiné à réduire la dissipation de puissance dans un amplificateur de ligne (2), l'amplificateur de ligne étant couplé à une ligne de transmission (3) afin de transmettre des signaux à tonalités multiples, sous la forme de symboles successifs (S1, S2) séparés par des préfixes cycliques (CP1, CP2), produits par un processeur de signal numérique (1), l'agencement comprenant une alimentation en tension régulable (5), qui a une borne de sortie et une borne d'entrée de commande, la borne de sortie de l'alimentation en tension régulable (5) étant connectée à une borne de tension d'alimentation (6) de l'amplificateur de ligne (2) afin de lui fournir une tension d'alimentation régulable, l'agencement étant **caractérisé en ce que** la borne d'entrée de commande de l'alimentation en tension régulable (5) est connectée à une borne de sortie de commande du processeur de signal numérique (1) via un bus de commande (4), le processeur de signal numérique (1) étant conçu pour commander l'alimentation en tension régulable (5) via le bus de commande (4) pendant chaque préfixe cyclique (CP1, CP2) en sélectionnant la tension d'alimentation de l'amplificateur de ligne (2) en réponse à une valeur crête-à-crête attendue du symbole suivant à transmettre.

2. Agencement selon la revendication 1, l'agencement étant **caractérisé en ce que** l'alimentation en tension régulable comprend un commutateur (5) qui est conçu pour appliquer des tensions d'alimentation différentes (SV1, SV2, ..., SVn) à l'amplificateur de ligne (2) en réponse à différentes valeurs crête-à-crête attendues des symboles à transmettre.

3. Agencement selon la revendication 1, l'agencement étant **caractérisé en ce que** l'alimentation en tension régulable comprend un convertisseur continu-continu commandé par le processeur de signal numérique (1).
